Europäisches Patentamt

European Patent Office

Office européen des brevets

(19)

(11) Veröffentlichungsnummer: **0 141 151**
**B1**

(12) ## EUROPÄISCHE PATENTSCHRIFT

(45) Veröffentlichungstag der Patentschrift:
16.12.87

(51) Int. Cl.⁴: **H 03 K 17/08**

(21) Anmeldenummer: **84110604.0**

(22) Anmeldetag: **06.09.84**

(54) Einrichtung zur Befreiung elektronischer Einwegschalter von hoher Verlustleistungsbeanspruchung.

(30) Priorität: **22.10.83 DE 3338462**

(43) Veröffentlichungstag der Anmeldung:
**15.05.85 Patentblatt 85/20**

(45) Bekanntmachung des Hinweises auf die Patenterteilung:
**16.12.87 Patentblatt 87/51**

(84) Benannte Vertragsstaaten:
**DE FR IT**

(56) Entgegenhaltungen:
**DE-A-3 132 512**

(73) Patentinhaber: **ANT Nachrichtentechnik GmbH, Gerberstrasse 33, D-7150 Backnang (DE)**

(72) Erfinder: **Ohms, Franz, Dipl.- Ing., Asangstrasse 168, D-7000 Stuttgart 61 (DE)**

(74) Vertreter: **Wiechmann, Manfred, Dipl.- Ing., ANT Nachrichtentechnik GmbH Gerbe.:strasse 33 Postfach 11 20, D-7150 Backnang (DE)**

EP 0 141 151 B1

**Beschreibung**

Die Erfindung betrifft eine Einrichtung gemäß dem Oberbegriff des Patentanspruchs 1. Eine solche Einrichtung ist bekannt aus DE-A- 31 32 512.

Elektronische Einwegschalter müssen insbesondere bei hohen Schaltfrequenzen von zu hoher Verlustleistungsbeanspruchung beim Ausschalten geschützt werden. Dazu wird üblicherweise in einem Nebenstromkreis des Einwegschalters ein Begrenzernetzwerk vorgesehen, welches bei verlustfreier Ausführung aus induktiven und kapazitiven Bauelementen sowie Dioden besteht, vgl. beispielsweise "Protection of Power Transistors in Electric Vehicle Drives", Thomas A. Radomski, 1982, IEEE Conf. Rec., Seiten 455 bis 465; DE 26 44 715 A 1. Beim Abschalten des Einwegschalters übernehmen diese Begrenzernetzwerke die Verlustleistung in Speicherelementen und schützen so den Einwegschalter. Beim Wiedereinschalten des elektronischen Schalters werden diese Speicherelemente umgeladen und sind zur Energieaufnahme bei erneutem Abschalten des Einwegschalters bereit.

Bei der Einrichtung gemäß DE-A - 31 32 512 ist ebenfalls ein Nebenstromkreis als Schutz für einen elektronischen Einwegschalter vorgesehen mit einem kapazitiven und induktiven Speicherelement. Im lastseitigen Stromkreis befindet sich eine Freilaufdiode zur Übernahme des Laststroms bei abgeschaltetem Einwegschalter. Ein weiteres kapazitives Speicherelement - Längsentlastungskondensator - ist als Bestandteil eines Ausschaltentlastungsnetzwerkes im Nebenstromkreis so geschaltet, daß es sich voll auf die Ausgangsspannung aufladen kann.

Aufgabe der Erfindung ist es, die Einrichtung gemäß dem Oberbegriff des Patentanspruchs derart auszugestalten, daß mit einfachem Schaltungsaufwand die Verlustleistungsbeanspruchung des elektronischen Einwegschalters weiter reduziert werden kann.

Erfindungsgemäß wird diese Aufgabe durch die kennzeichnenden Merkmale des Patentanspruchs gelöst.

Bei der Erfindung wird außer der Reduzierung der Verlustleistungsbeanspruchung beim Ein- und Ausschalten des Einwegschalters der Erholstrom der Freilaufdiode begrenzt. Darüber hinaus arbeitet diese Einrichtung noch lastabhängig, d.h. bei kleineren Strömen wirkt die Schaltung vermindert. Bei bisher bekannten verlustfreien Entlastungsschaltungen, z. B. DE 26 44 715 A 1, ergeben sich Probleme bei Teillast- oder Leerlaufbetrieb. Der Wirkungsgrad verschlechtert sich dort, da der Ladungsumsatz und damit die Verlustleistung dieser Entlastungsschaltungen unabhängig vom Laststrom konstant bleiben. Diese Problematik wird bei der Erfindung durch die lastabhängige Ent- bzw. Nachladung des weiteren kapazitiven Speicherelementes geläst. Die Verlustleistung der Entlastungsschaltung ist nämlich nicht prinzipbedingt, sondern rührt von Diodenschwellspannungen sowie ohmschen Verlusten in den Bauelementen des Entlastungskreises her, die sich in Abhängigkeit der Belastung zum Teil ändern. Hohe Magnetisierungsströme zur Vermeidung von Entmagnetisierungsproblemen bei Leerlaufbetrieb sind bei Transformatoranwendungen nicht mehr nötig. Während zur Reduzierung der Verlustleistungsbeanspruchung sowie zur Begrenzung der Erholströme bislang jeweils getrennte Schaltungen erforderlich waren, ist die Einrichtung gemäß der Erfindung in der Lage, beide Maßnahmen gleichzeitig mit einer einfachen Schaltung zu erfüllen.

Die Schaltungen nach der Erfindung sind universell einsetzbar, beispielsweise für Tiefsetz- und Hochsetzsteller, Sperr- und Flußwandler, sowie Gegentakt- und Brückenwandler. Die Einrichtung nach der Erfindung eignet sich besonders für hohe Schaltfrequenzen des Einwegschalters, da die Schaltverluste üblicherweise bei hohen Frequenzen besonders stark hervortreten und den Wirkungsgrad verschlechtern.

Zusätzliche Rückwärtserholströme belasten den Einwegschalter nicht. Maßnahmen gegen das Abreißen des Rückwärtserholstromes verbunden mit Spannungsspitzen, hervorgerufen durch Streuinduktivitäten sowie elektromagnetische Felder, die aufwendige Entstörmaßnahmen erfordern, müssen nicht mehr getroffen werden.

Anhand der Figuren wird die Erfindung nun näher erläutert. Es zeigen

Fig. 1 eine Prinzipschaltung der Einrichtung nach der Erfindung,

Fig. 2 Signalverläufe an den Schaltelementen der Einrichtung nach Fig. 1,

Fig. 3 eine Einrichtung mit Speisung des weiteren Kondensators aus dem Freilaufdiodenkreis,

Fig. 4 Signalverläufe an den Schaltelementen der Einrichtung nach Fig. 3 und die

Fig. 5 bis 8 verschiedene Anwendungen der Einrichtung nach der Erfindung.

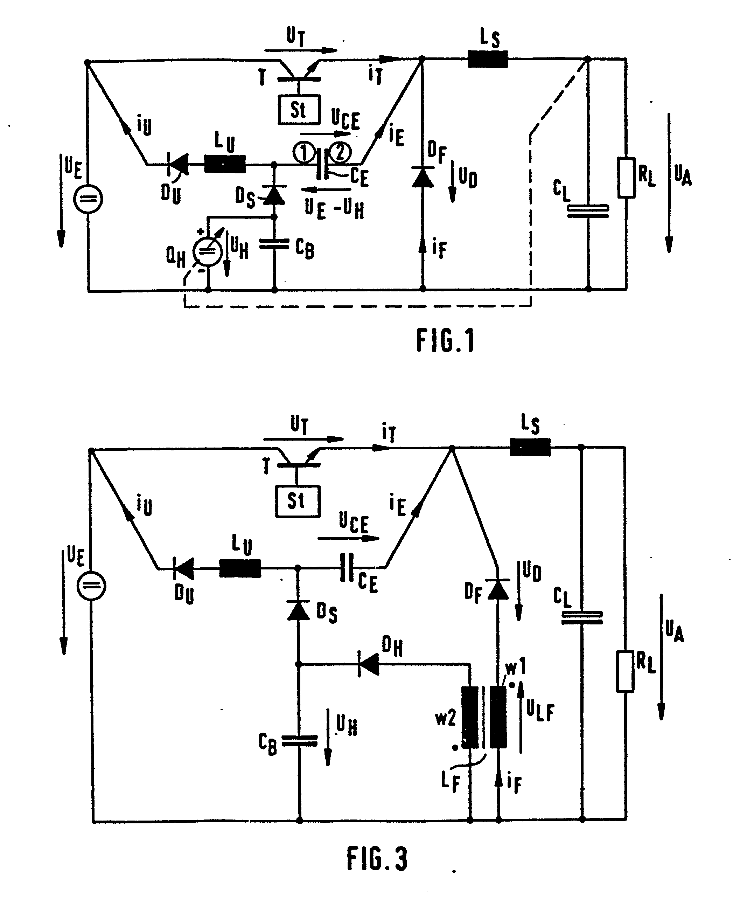

In Fig. 1 ist eine Grundschaltung zur Erläuterung des Prinzips der Erfindung dargestellt. Die Eingangsgleichspannung ist mit $U_E$ bezeichnet. Über den elektronischen Einwegschalter T, hier als Bipolartransistor ausgebildet, wird diese Eingangsgleichspannung $U_E$ zeitweise mit der Last, dargestellt durch einen Lastwiderstand $R_L$, verbunden. Der Bipolartransistor T wird von der Steuereinrichtung St leitend gesteuert, z. B. im Schaltreglerbetrieb. Zur Glättung des Stromes über den Einwegschalter T zur Last $R_L$ ist eine Glättungsdrossel $L_S$ in Reihe zu T und $R_L$ vorgesehen. Die Induktivität dieser Glättungsdrossel $L_S$ ist als sehr hoch angenommen. Parallel zur Last $R_L$ liegt ein Glättungskondensator $C_L$. Damit der Laststrom auch bei abgeschaltetem Einwegschalter T weiterfließen kann, liegt parallel zur Reihenschaltung, bestehend aus $L_S$ und $R_L$ eine Freilaufdiode $D_F$. Die Emitter-Kollektorstrecke des Einwegschalters T ist durch die Reihenschaltung, bestehend aus einem ersten kapazitiven Speicherelement $C_E$, einer Umschwingdrossel $L_U$ und einer Diode $D_U$, deren Durchlaßrichtung vom Emitter zum Kollektor des Einwegschalters weist, überbrückt. An die Verbindungsleitung zwischen dem ersten kapazitiven Speicherelement $C_E$ und der Umschwingdrossel $L_U$ ist eine Diode $D_S$ katodenseitig angekoppelt. Die Anode dieser Diode $D_S$ ist mit einer Elektrode eines weiteren kapazitiven Speicherelementes $C_B$ verbunden. Die andere Elektrode dieses weiteren kapazitiven Speicherelementes $C_B$ ist mit der Anode der Freilaufdiode $D_F$ und mit jenem Pol der Eingangsgleichspannungsquelle verbunden, welcher nicht zum Einwegschalter T führt. Parallel zum weiteren kapazitiven Speicherelement $C_B$ liegt eine Hilfsspannungsquelle $Q_H$, an der eine Hilfsspannung $U_H$ abfällt. Der positive Anschlußpol von $Q_H$ weist dabei zur Anode von $D_S$.

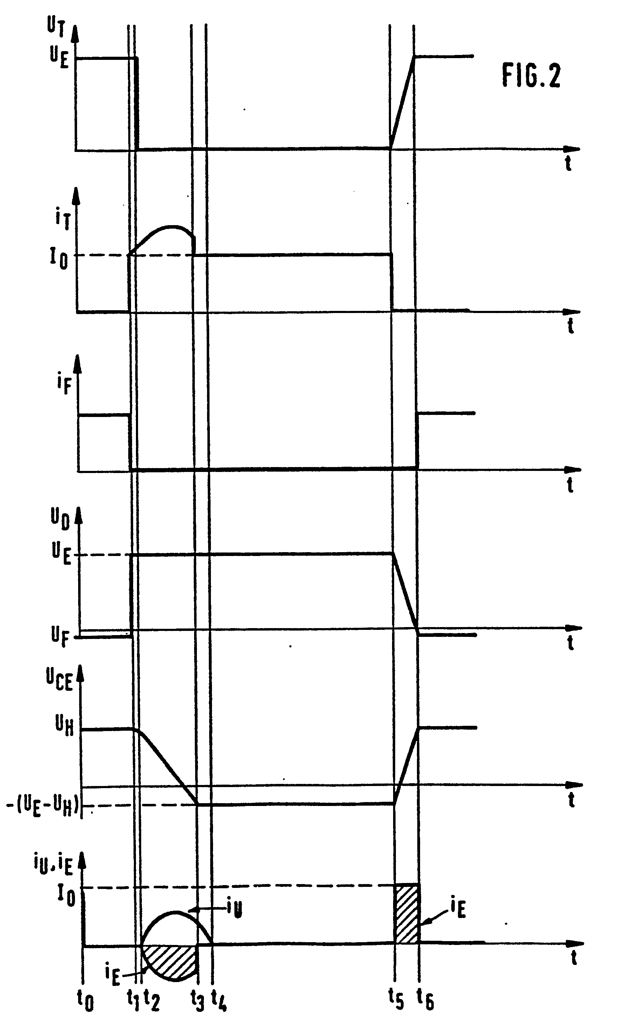

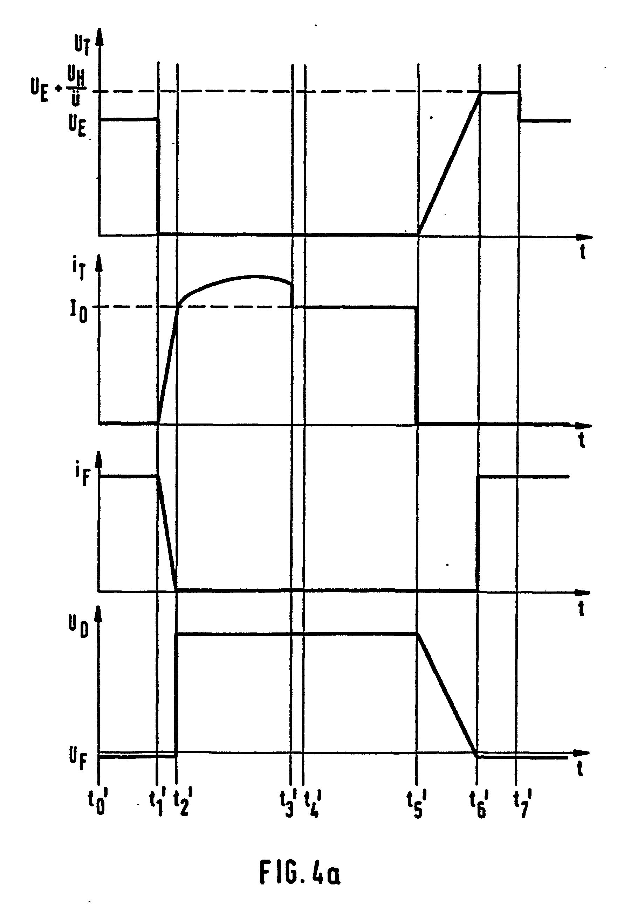

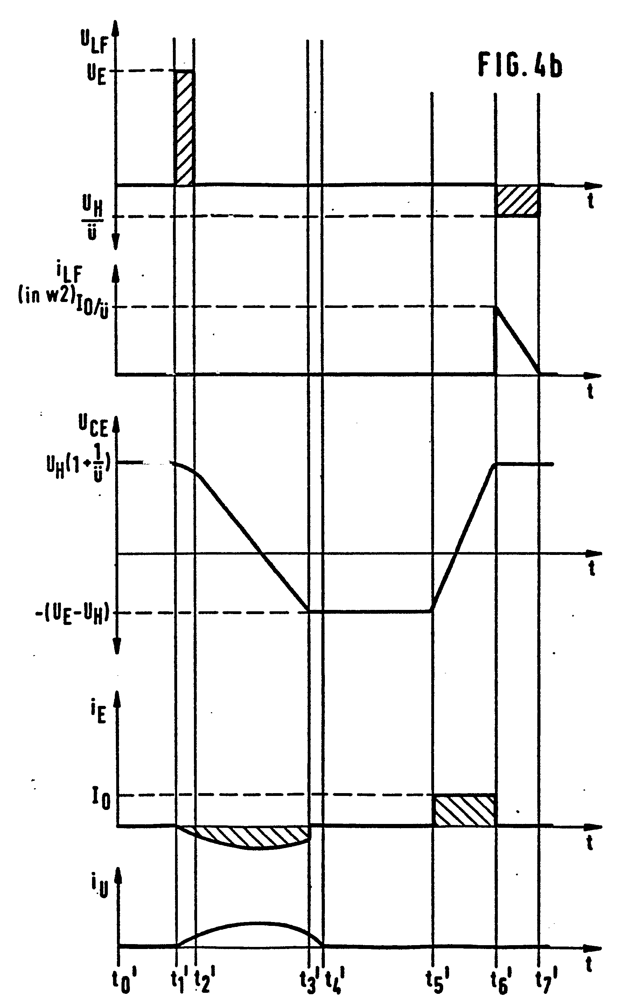

Die Funktion der Schaltung gemäß Fig. 1 wird nun anhand der Signalverläufe von Fig. 2 erläutert. Zum Zeitpunkt $t_0$ sei der Einwegschalter T geöffnet. Die Spannung $U_T$ an der Emitter-Kollektorstrecke von T beträgt die volle Eingangsspannung $U_E$, vgl. Fig. 2, 1. Zeile. Zum Zeitpunkt $t_1$ wird der Einwegschalter T über die Steuereinrichtung St geschlossen. Es fließt ein Kollektor-Emitterstrom $i_T$, Fig. 2, 2. Zeile. Der Strom $i_F$ durch die Freilaufdiode $D_F$, Fig. 2, 3. Zeile, endet. Die Spannung $U_D$ an der Freilaufdiode $D_F$ springt vom negativen Schwellwert $U_F$ auf den positiven Wert der Eingangsspannung $U_E$, Fig. 2, 4. Zeile. Obwohl der Strom $i_T$ durch den Einwegschalter T ab dem Zeitpunkt $t_1$ schon fließt, liegt an der Emitter-Kollektorstrecke von T immer noch die volle Eingangsspannung $U_E$ und zwar bis zum Zeitpunkt $t_2$. Da der Kondensator $C_E$ zuvor geladen wurde und eine Polarität aufweist, wie es der Spannungspfeil $U_{CE}$ über $C_E$ anzeigt, fließt von der mit 1 bezeichneten Elektrode des Kondensators $C_E$ ein Umschwingstrom $i_U$ über die Umschwingdrossel $L_U$, die Diode $D_U$, die Kollektor-Emitterstrecke des Einwegschalters T zurück zur Elektrode 2 des Kondensators $C_E$. Dieser Umschwingstrom $i_U$, dargestellt in Fig. 2, letzte Zeile, fließt vom Zeitpunkt $t_2$, also wenn $U_T = 0$ wird, bis zum Zeitpunkt $t_4$ jedoch nur bis zum Zeitpunkt $t_3$ über den Einwegschalter T zurück zur Elektrode 2 von $C_E$. Während des Zeitraumes $t_3$ bis $t_4$ fließt der Umschwingstrom $i_U$, gespeist aus der Hilfsspannungsquelle $Q_H$, parallel zum weiteren Kondensator $C_B$, über die Diode $D_U$ auf die Eingangsspannungsquelle zurück - Energierückspeisung. Der Zeitpunkt $t_3$ läßt sich durch Variation der Höhe der

Hilfsspannung $U_H$ einstellen. Der Zeitpunkt $t_3$ ist nämlich durch jene Zeit bestimmt, bis zu der sich die Spannung $U_{CE}$ über dem Kondensator $C_E$ vom positiven Wert $U_E$ auf den negativen Wert ($U_E - U_H$) umkehrt, Fig. 2, vorletzte Zeile. Der Strom $i_E$ durch den Kondensator $C_E$ endet also bereits zum Zeitpunkt $t_3$, Fig. 2, letzte Zeile. Der Strom $i_T$ durch den Einwegschalter T setzt sich im Zeitraum $t_1$ bis $t_3$ aus dem Strom $I_0$ und dem Strom $i_E$ zusammen. Gewinnt man aus der Spannung $U_A$ an der Last $R_L$ ein Kriterium zur Variation der Hilfsspannung $U_H$, so läßt sich die Schaltung gemäß Fig. 1 lastabhängig steuern; d.h. die Menge der zurückgespeisten Energie wird von der Last bestimmt.

Zum Zeitpunkt $t_5$ wird der Einwegschalter T mittels der Steuereinrichtung St ausgeschaltet. Der Strom $i_T$ endet. Die Freilaufdiode $D_F$ übernimmt nun nicht schlagartig den Laststrom, sondern es fließt ein Strom $i_E$ zwischen den Zeitpunkten $t_5$ und $t_6$, der vom Energieinhalt des Kondensators $C_B$ getrieben wird. Dieser Strom $i_E$, Fig. 2, letzte Zeile, fließt über den Kondensator $C_B$, die Diode $D_S$, den Kondensator $C_E$, die Drossel $L_S$ und über den Lastwiderstand $R_L$ zurück zum Kondensator $C_B$. Dieser Strom $i_E$ zwischen $t_5$ und $t_6$ fließt so lange, wie es dem Strom-Zeit-Integral von $i_E$ im Intervall von $t_1$ bis $t_3$ entspricht (Ladungserhaltungssatz). Die Spannung $U_{CE}$ am Kondensator $C_E$ ändert während dieser Zeit ihre Polarität von $U_E - U_H$ auf $U_H$, Fig. 2, vorletzte Zeile. Über dem Einwegschalter T baut sich die Sperrspannung $U_T$ stetig auf. Die Spannung an der Freilaufdiode $D_F$ wechselt von $U_E$ auf den negativen Schwellwert $U_F$. Ab dem Zeitpunkt $t_6$ übernimmt die Freilaufdiode $D_F$ den Laststrom. Es fließt der Strom $i_F$, Fig. 2, Zeile 3.

Wie aus Fig. 2 ersichtlich ist, entsteht beim Ausschalten des Einwegschalters T keine Spannungsspitze, die ihn zerstören könnte. Die Sperrspannungsbeanspruchung von T ist auf den Wert der Eingangsgleichspannung $U_E$ begrenzt.

Fig. 3 zeigt eine Schaltung nach der Erfindung mit erfindungsgemäßer Speisung des weiteren kapazitiven Speicherelements aus dem Freilaufdiodenkreis. Das weitere kapazitive Speicherelement $C_B$ wird hier nicht von einer separaten Hilfsspannungsquelle gespeist, sondern die Hilfsspannung $U_H$ wird aus dem Freilaufdiodenkreis generiert. Parallel zur Kollektor-Emitterstrecke des Einwegschalters T liegen die gleichen Schaltelemente wie in Fig. 1. Auch das weitere kapazitive Speicherelement $C_B$ und die Diode $D_S$ sind wie in Fig. 1 angeordnet. In Reihe zur Freilaufdiode $D_F$ befindet sich in Abweichung zu Fig. 1 eine Freilaufdrossel $L_F$ mit einer Hauptwicklung w1. Diese Freilaufdrossel $L_F$ trägt eine Hilfswicklung w2. Die Hilfswicklung w2 ist über eine Diode $D_H$ derart mit dem weiteren kapazitiven Speicherelement $C_B$ verbunden, daß die in der Hilfswicklung w2 induzierte Spannung als Hilfsspannung $U_H$ zum Nachladen des weiteren kapazitiven Speicherelementes $C_B$ herangezogen werden kann.

Anhand der Signalverläufe von Fig. 4 wird die Funktionsweise der Schaltung gemäß Fig. 3 nun näher erläutert. Zum Zeitpunkt $t_0'$ sei der Einwegschalter T wieder geöffnet.

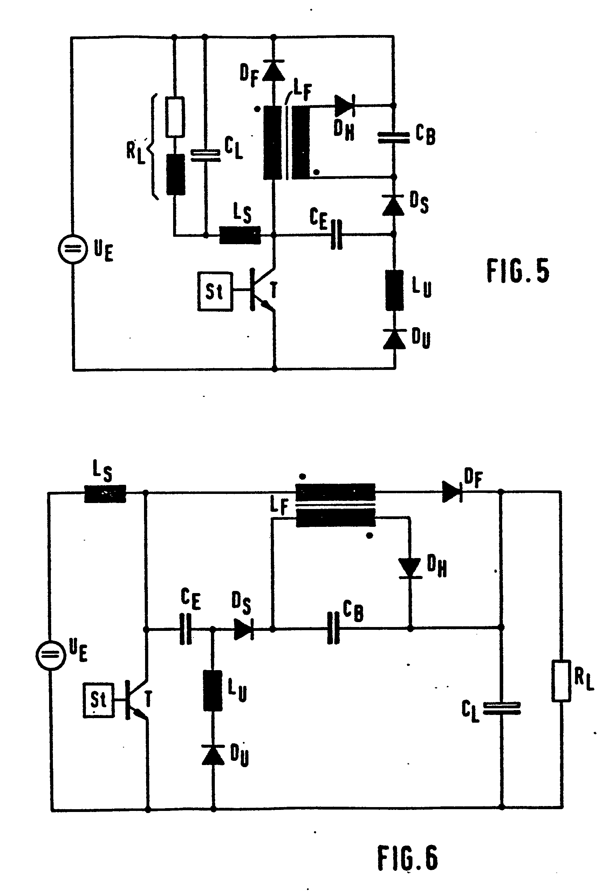

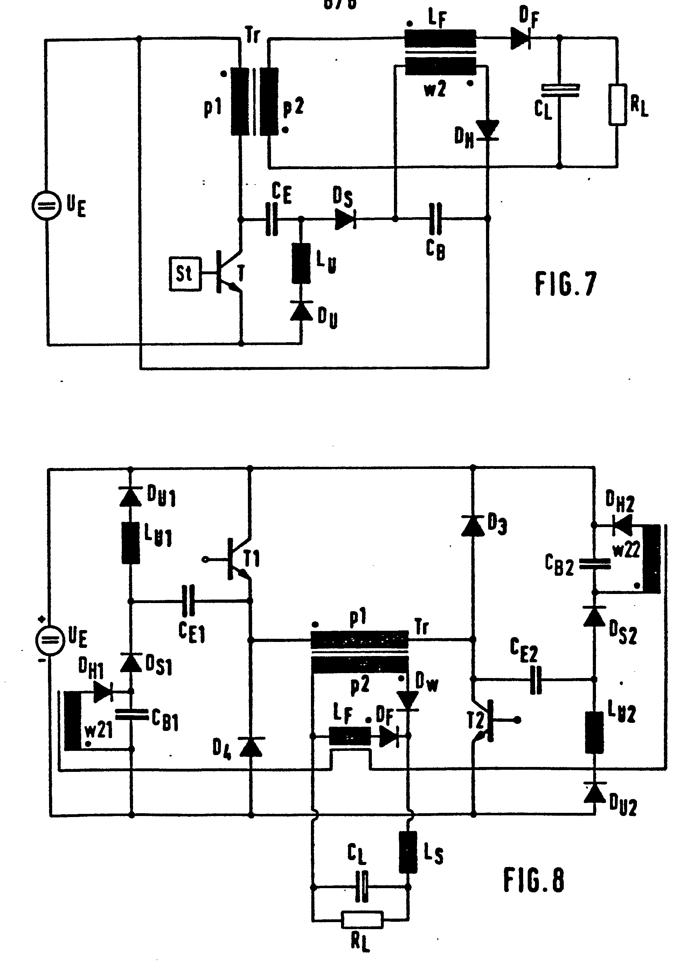

An der Emitter-Kollektorstrecke fällt die Spannung $u_T = U_E$, Fig. 4, 1. Zeile, ab. Zum Zeitpunkt $t_1'$ wird der Einwegschalter T mittels eines Steuerimpulses von St an seiner Basis geschlossen. Der Laststrom kann nun nicht schlagartig vom Freilaufkreis (Strom $i_F$, Fig. 4, 3. Zeile) in den Schalterkreis kommutieren (Strom $i_T$, Fig. 4, 2. Zeile) wegen der Stetigkeit des Laststromes $I_0$ durch die Hauptinduktivität der Freilaufdrossel $L_F$. Der Kollektor-Emitterstrom $i_T$ wächst im Zeitraum $t_1'$ bis $_2t'$ auf den Wert $I_0$ an, Fig. 4, Zeile 2. Der Strom $i_F$ durch die Freilaufdiode $D_F$, der von $t_0'$ bis $t_2'$ einen konstanten Wert einnahm, sinkt demgegenüber im Intervall von $t_1'$ bis $t_2'$ auf 0 ab. Der Kondensator $C_E$ lädt sich ab dem Zeitpunkt $t_1'$ von der Spannung $U_H (1 + \frac{1}{ü})$, wobei ü das Übersetzungsverhältnis der Wicklungen w2/w1 darstellt, auf die Spannung $- (U_E - U_H)$ um, Fig. 4, 7. Zeile. Diese Umladung ist beendet, wenn die Summenspannung $U_{CE} + U_H$ den Wert der Eingangsspannung $U_E$ erreicht hat - Zeitpunkt $t_3'$. Es fließt wie beim Ausführungsbeispiel nach Fig. 1 nach dem Zeitpunkt $t_3'$ nun kein Strom $i_E$ mehr durch den Kondensator $C_E$ und den Einwegschalter T, Fig. 4, vorletzte Zeile, sondern bis zum Zeitpunkt $t_4'$ nur noch ein Strom $i_U$ über die Umschwingungdrossel $L_U$ und die Diode $D_U$ auf die Eingangsgleichspannungsquelle, Fig. 4, letzte Zeile. An der Hauptwicklung der Freilaufdrossel $L_F$ steht im Intervall $t_1'$ bis $t_2'$ die Spannung $u_{LF} = U_E$ an. Zum Zeitpunkt $t_5'$ wird der Einwegschalter T mittels St geöffnet. Der Strom $i_T$ durch den Einwegschalter endet sofort, Fig. 4, 2. Zeile. Die Spannung $u_T$ über der Kollektor-Emitterstrecke wächst bis zum Zeitpunkt $t_6'$ von 0 bis auf den Wert $U_E + \frac{U_H}{ü}$ stetig an, Fig. 4, 1. Zeile. Die Spannung $u_D$ an der Freilaufdiode $D_F$ geht linear auf den negativen Schwellwert $U_F$ zurück, Fig. 4, 4. Zeile. Im Intervall $t_5'$ bis $t_6'$, wenn der Strom $i_T$ durch den Einwegschalter T beendet ist, fließt der Laststrom als Strom $i_E$ weiter und zwar über den Kondensator $C_B$, die Diode $D_S$ und den Kondensator $C_E$. Der Kondensator $C_B$ entlädt sich hierbei. In diesem Intervall $t_5'$ und $t_6'$ kehrt sich die Spannung $U_{CE}$ am Kondensator $C_E$ von $-(U_E - U_H)$ auf $U_H (1 + \frac{1}{ü})$ um, Fig. 4, 7. Zeile. Der Kondensator $C_B$ wird vorzugsweise etwa 50 mal größer gewählt als $C_E$. Da ab dem Zeitpunkt $t_6'$ an der Freilaufdrossel $L_F$ die transformierte Zwischenspannung $u_{LF} = \frac{U_H}{ü}$ anliegt, Fig. 4, Zeile 5, kommutiert der Laststrom aus dem Entlastungskreis (Strom $i_E$, Fig. 4, vorletzte Zeile) in den Freilaufkreis (Strom $i_F$, Fig. 4, 3. Zeile). Der Kondensator $C_B$ wird nun, gespeist aus dem Freilaufkreis, über die Hilfswicklung w2 und die Diode $D_H$ aufgeladen. Die eingeprägte Zwischenspannung $\frac{U_H}{ü}$ an der Freilaufdrossel $L_F$ führt dazu, daß der Laststrom in die Hauptinduktivität der Freilaufdrossel $L_F$ kommutiert (Strom $i_{LF}$, Fig. 4, 6. Zeile). Dieser Vorgang endet beim Zeitpunkt $t_7'$. Die Spannung $u_T$ an der Kollektor-Emitterstrecke des Einwegschalters T geht ab dem Zeitpunkt $t_7'$ wieder auf den Wert von $U_E$ zurück.

Die Hilfsspannung $U_H$ am weiteren kapazitiven Speicherelement $C_B$ stellt sich so ein, daß der Ladungserhaltungssatz erfüllt ist. Bei Kleinlast oder Leerlauf lädt sich der Kondensator $C_B$ nur unwesentlich auf. Damit wirkt die Entlastungsschaltung nur in geringem Maße. Dies ist erwünscht, da kaum Umladungen stattfinden, die Verlustleistung erzeugen.

Die bisher vorgestellten Ausführungsbeispiele bezogen sich auf einen Einwegschalter in Anwendung für einen Tiefsetzsteller ("buck" - oder "step-down converter"). In Fig. 5 wird nun eine Schaltungsvariante eines solchen Tiefsetzstellers gezeigt. Fig. 6 zeigt einen Hochsetzsteller ("boost" - oder "step-up converter") und die Figuren 7 und 8 einen Sperr- bzw. einen Flußwandler.

Beim Tiefsetzsteller nach Fig. 5 ist die Eingangsgleichspannungsquelle $U_E$ mit der Reihenschaltung, bestehend aus Freilaufdiode $D_F$, Hauptwicklung der Freilaufdrossel $L_F$ und Kollektor-Emitterstrecke des Einwegschalters T, verbunden. Parallel zur Hauptwicklung der Freilaufdrossel $L_F$ und der Freilaufdiode $D_F$ liegt die Reihenschaltung der Glättungsdrossel $L_S$ und Lastwiderstand $R_L$ mit induktivem Anteil. Wie beim Ausführungsbeispiel nach Fig. 3 ist die Kollektor-Emitterstrecke von T durch die Reihenschaltung, bestehend aus Kondensator $C_E$, Umschwingdrossel $L_U$ und Diode $D_U$ überbrückt. An die Verbindungsleitung von $C_E$ nach $L_U$ ist anodenseitig die Diode $D_S$ angekoppelt, welche katodenseitig mit dem weiteren Kondensator $C_B$ verbunden ist. Der Kondensator $C_B$ ist durch die Reihenschaltung der Hilfswicklung von $L_F$ und Diode $D_H$ überbrückt. Die der Diode $D_S$ abgewandte Elektrode von $C_B$ ist mit der Katode von $D_F$ verbunden, die an die Eingangsgleichspannungsquelle $U_E$ angeschlossen ist.

Beim Hochsetzsteller nach Fig. 6 liegt die Eingangsgleichspannungsquelle $U_E$ parallel zur Reihenschaltung aus der Glättungsdrossel $L_S$ und der Kollektor-Emitterstrecke des Einwegschalters T. Parallel zur Kollektor-Emitterstrecke von T liegt wieder das Begrenzernetzwerk $C_E$, $L_U$, $D_U$. An die Verbindungsleitung von $L_S$ und Kollektor von T ist die Hauptwicklung der Freilaufdrossel $L_F$ angeschlossen, zu welcher wiederum die Freilaufdiode $D_F$ und der Lastwiderstand $R_L$ in Serie liegt. Der Hilfswicklung der Freilaufdrossel $L_H$ ist die Reihenschaltung von $C_B$ und $D_H$ parallel geschaltet. Die Diode $D_S$ verbindet die Verbindungsleitung $C_E$, $L_U$ mit einer Elektrode von $C_B$. Die andere Elektrode von $C_B$, an die auch die Katode von $D_H$ angeschlossen ist, führt einerseits zur Katode von $D_F$ und zur einen Anschlußklemme von $R_L$ und andererseits über den Glättungskondensator $C_L$ zur anderen Anschlußklemme von $R_L$.

Beim Sperrwandler nach Fig. 7 liegt parallel zur Eingangsspannungsquelle $U_E$ die Reihenschaltung aus Primärwicklung p1 des Sperrwandlertransformators Tr und die Kollektor-Emitterstrecke des Einwegschalters T. Über der Kollektor-Emitterstrecke von T liegt wieder die Begrenzerschaltung, bestehend aus $C_E$, $L_U$ und $D_U$. Die Sekundärwicklung p2 des Sperrwandlertransformators Tr ist über die Freilaufdrossel $L_F$ und die Freilaufdiode $D_F$ an die Last $R_L$ angeschlossen. Ein Wicklungsende der Hilfswicklung w2 von $L_F$ ist über die Diode $D_S$ an die Verbindungsleitung zwischen $C_E$ und $L_U$ und eine Elektrode des Kondensators $C_B$ angeschlossen. Das andere Wicklungsende von $w_2$ ist über die Diode $D_H$ sowohl mit der anderen Elektrode vom Kondensator $C_B$ als auch mit jener Anschlußklemme der Eingangsgleichspannungsquelle $U_E$ verbunden, die der Primärwicklung p1 von Tr benachbart ist.

Fig. 8 zeigt schließlich eine Anwendung der Einrichtung nach der Erfindung für einen Durchflußwandler und zwar für einen Durchflußwandler in Halbbrückenschaltung. Die Einwegschalter T1 und T2 sind je in einem Längszweig der Halbbrückenschaltung angeordnet. Die Dioden $D_3$ und $D_4$ liegen als Ergänzung der Halbbrückenschaltung in Reihe zu je einem der Einwegschalter T1 und T2. Jedem Einwegschalter T1, T2 ist bezüglich seiner Emitter-Kollektorstrecke ein Begrenzernetzwerk, bestehend aus einem Kondensator $C_{E1}$ bzw. $C_{E2}$, einer Umschwingdrossel $L_{U1}$ bzw. $L_{U2}$, und einer Diode $D_{U1}$ bzw. $D_{U2}$, parallel geschaltet. An die Verbindungsleitung von $C_{E1}$ mit $L_{U1}$ ist die Diode $D_{S1}$ angeschlossen, deren von dieser Verbindungsleitung abgewandte Elektrode über die Diode $D_{H1}$ mit einer ersten Hilfswicklung w21 der Freilaufdrossel $L_F$ und mit dem Kondensator $C_{B1}$ verbunden ist. Ebenso ist an die Verbindungsleitung von $C_{E2}$ mit $L_{U2}$ die Diode $D_{S2}$ angeschlossen, deren von der Verbindungsleitung abgewandte Elektrode über die Diode $D_H$ mit einer zweiten Hilfswicklung w22 der Freilaufdrossel $L_F$ und mit dem Kondensator $C_{B2}$, verbunden ist. In der Brückendiagonale der Halbbrückenschaltung liegt die Primärwicklung p1 des Wandlertransformators Tr. Die Sekundärwicklung p2 dieses Wandlertransformators Tr ist über die Diode $D_W$ und die Glättungsdrossel $1_S$ mit der Last $R_L$ verbunden. Die Freilaufdiode $D_F$ in Reihe mit der Hauptwicklung der Freilaufdrossel $L_F$ liegt parallel zur Reihenschaltung, bestehend aus p2 und $D_W$.

Neben den vorgestellten Anwendungsmöglichkeiten bieten sich für die Einrichtung gemäß der Erfindung zahlreiche andere Anwendungsmöglichkeiten, z. B. kombinierter Hochsetz/Tiefsetzsteller, Gegentaktwandler in Vollbrückenschaltung, Kombinationen von Tiefsetzstellern zu Wechselrichtern, an.

## Patentansprüche

Einrichtung zur Befreiung elektronischer Einwegschalter von hoher Verlustleistungsbeanspruchung beim Ein- und Ausschalten, wobei der elektronische Einwegschalter über eine Versorgungsspannungsquelle ($U_E$) unmittelbar oder mittelbar mit einer Last verbindbar ist, wobei in einem Nebenstromkreis des elektronischen Einwegschalters (T) mindestens ein induktives und ein kapazitives Speicherelement ($C_E$) angeordnet ist, wobei im lastseitigen Stromkreis eine Freilaufdiode ($D_E$) zur Übernahme des Laststromes bei abgeschaltetem Einwegschalter (T) liegt, wobei das kapazitive Speicherelement ($C_E$) im Nebenstromkreis mit einem weiteren kapazitiven Speicherelement ($C_B$), welches von einer Hilfsspannungsquelle ($Q_H$) geladen wird, derart beschaltet ist, daß im Anschluß an das Abschalten des elektronischen Einwegschalters (T) bis zur Stromübernahme durch die Freilaufdiode ($D_F$) aus diesem weiteren kapazitiven Speicherelement ($C_B$) über das kapazitive Speicherelement ($C_E$) der Laststrom getrieben wird, dadurch gekennzeichnet, daß in den Stromkreis der Freilaufdiode ($D_F$) eine Freilaufdrossel ($L_F$) geschaltet ist, daß diese Freilaufdrossel ($L_F$) eine Hilfswicklung (w2) trägt, und daß diese Hilfswicklung (w2) derart mit dem weiteren kapazitiven Speicherelement ($C_B$) verbunden ist, daß die in der Hilfswicklung (w2) induzierte Spannung als Hilfsspannungsquelle ($Q_H$) zum Laden des kapazitiven Speicherelements ($C_B$) benutzbar ist.

## Claim

1. Device for freeing electronic one-way switches from high power loss stresses during turn-on and turn-off, with the electronic one-way switch being connectable, via a supply voltage source ($U_E$), directly or indirectly with a load and at least one inductive and one capacitive storage element ($C_E$) being disposed in an ancillary circuit of the electronic one-way switch (T), with a free-wheeling diode ($D_E$) being disposed in the load-side circuit for taking over the load current if the one-way switch (T) is turned off and the capacitive storage element ($C_E$) in the ancillary circuit being connected with a further capacitive storage element ($C_B$) which is charged by an auxiliary voltage source ($Q_H$) in such a manner that, following turn-off of the electronic one-way switch (T), until the current is taken over by the free-wheeling diode ($D_F$), the load current is driven from said further capacitive storage element ($C_B$) via the capacitive storage element ($C_E$), characterized in that a free-wheeling choke ($L_F$) is connected in the circuit of the free-wheeling diode ($D_F$), said free-wheeling choke ($L_F$) is equipped with an auxiliary winding (w2);

and said auxiliary winding (w2) is connected with the further capacitive storage element ($C_B$) in such a manner that the voltage induced in the auxiliary winding (w2) can be used as an auxiliary voltage source ($Q_H$) for charging the capacitive storage element ($C_B$).

**Revendication**

1. Dispositif d'élimination d'une forte sollicitation d'interrupteurs électroniques à une voie par la puissance dissipée, dans lequel l'interrupteur électronique à une voie peut être relié par une source de tension d'alimentation ($U_E$) directement ou indirectement à une charge; un circuit en dérivation sur l'interrupteur électronique à une voie (T) contient au moins un composant accumulateur inductif et capacitif ($C_E$); le circuit c°oté charge contient une diode de roue libre ($D_E$) pour le transfert du courant de charge quand l'interrupteur à une voie est ouvert (T); l'élément accumulateur capacitif ($C_E$) du circuit en dérivation est relié à un second composant accumulateur capacitif ($C_B$) chargé par une source de tension auxiliaire ($U_H$) de façon que ce second composant accumulateur capacitif ($C_B$) fasse circuler le courant de charge dans le composant accumulateur capacitif ($C_E$), depuis l'ouverture de l'interrupteur électronique à une voie (T) jusqu'à la reprise du courant par la diode de roue libre ($D_F$), ledit dispositif étant caractérisé en ce qu'une inductance de roue libre ($L_F$) est insérée dans le circuit de la diode de roue libre ($D_F$); l'inductance de roue libre ($L_F$) porte un enroulement auxiliaire (w2); et l'enroulement auxiliaire (w2) est relié au second composant accumulateur capacitif ($C_B$), de façon que la tension induite dans ledit enroulement auxiliaire (w2) soit utilisable comme source de tension auxiliaire ($Q_H$) pour la charge du composant accumulateur capacitif ($C_B$).

FIG.1

FIG.3

FIG.2

0 141 151

3

FIG. 4a

FIG. 4b

$U_{LF}$

$U_E$

$\dfrac{U_H}{\ddot{u}}$

$i_{LF}$
$(in\ w2)_{I0/\ddot{u}}$

$U_{CE}$

$U_H(1+\dfrac{1}{\ddot{u}})$

$-(U_E-U_H)$

$i_E$

$I_0$

$i_U$

$t_0'$ $t_1'$ $t_2'$ $t_3'$ $t_4'$ $t_5'$ $t_6'$ $t_7'$ $t$

FIG.5

FIG.6

FIG.7

FIG.8